# FASCICULE DE BREVET EUROPEEN

(11) **EP 3 171 244 B1**
(45) Date de publication et mention de la délivrance du brevet: **28.09.2022**
(21) Numéro de dépôt: 16162519.9
(22) Date de dépôt: 29.03.2016
(51) Int. Cl.: G06F 1/24, G06F 1/32, G06F 1/28, G06F 1/3203, H03K 19/00

(54) **MISE EN VEILLE D'UN CIRCUIT ÉLECTRONIQUE**
STAND-BY-SCHALTUNG EINES ELEKTRONISCHEN SCHALTKREISES
PLACEMENT OF AN ELECTRONIC CIRCUIT IN STANDBY

(30) Priorité: 20.11.2015 FR 1561202
(43) Date de publication de la demande: 24.05.2017
(73) Titulaire: STMICROELECTRONICS (ROUSSET) SAS, 13790 Rousset (FR)
(72) Inventeur: FROIDEVAUX, Nicolas, 13100 Aix-en-Provence (FR); GRIL-MAFFRE, Jean-Michel, 13090 Aix-en-Provence (FR); LECA, Jean-Pierre, 13100 Aix-en-Provence (FR)
(74) Mandataire: Cabinet Beaumont

(56) Documents cités:
- EP-A1- 1 102 158
- EP-A2- 0 537 525
- EP-B1- 0 746 817
- US-A1- 2005 034 016
- US-A1- 2010 064 160
- US-A1- 2014 089 708

## Description

### Domaine

La présente description concerne de façon générale les circuits électroniques et, plus particulièrement, la mise en veille d'un microcontrôleur.

### Exposé de l'art antérieur

Dans de nombreuses applications, on souhaite minimiser la consommation électrique d'un circuit électronique lorsque ce dernier n'est pas utilisé. On prévoit alors des mécanismes de mise en veille qui permettent de réduire la consommation du circuit.

Dans des circuits électroniques comportant un microcontrôleur, ce dernier intègre généralement des fonctions de mise en veille permettant de mettre en veille son coeur pendant des périodes où il n'est pas utilisé. Pendant ces périodes de veille, d'autres circuits du microcontrôleur surveillent les entrées-sorties du microcontrôleur afin de détecter un besoin de réveil du coeur.

Le document EP 0 746 817 décrit un mécanisme de retard de mise sous tension d'un microcontrôleur.

Le document US 2005/0034016 décrit un microcontrôleur avec une protection logique contre des décharges électrostatiques.

Le document US 2014/0089708 décrit un système à microcontrôleur avec module de retardement d'interruptions.

### Résumé

Il serait souhaitable de réduire la consommation résiduelle d'un microcontrôleur, y compris pendant des périodes de veille.

Un mode de réalisation pallie tout ou partie des inconvénients des circuits usuels de mise en veille d'un microcontrôleur.

Un mode de réalisation propose une solution aisée à mettre en oeuvre.

Ainsi, un mode de réalisation prévoit un microcontrôleur comportant :
un coeur ;
une unité de gestion de l'alimentation du coeur, comportant au moins une entrée de réception d'un signal externe de sortie d'un mode de veille ; et
un module interceptant ledit signal externe et le transmettant avec retard à ladite unité de gestion.

Selon un mode de réalisation, ladite unité de gestion comporte une fonction logique de mémorisation dudit signal d'entrée.

Selon un mode de réalisation, ladite fonction logique est réinitialisée par l'unité de gestion à l'issue dudit retard.

Selon un mode de réalisation, ledit module reçoit la sortie de ladite fonction logique et la combine avec une information représentative de la tension d'alimentation du microcontrôleur.

Selon un mode de réalisation, ledit module déclenche une temporisation quand le niveau de la tension d'alimentation atteint un seuil.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de façon schématique, un mode de réalisation d'un microcontrôleur ;
la figure 2 est un schéma bloc représentant un mode de réalisation d'un circuit de mise en veille du microcontrôleur ;
la figure 3 est un schéma bloc représentant un mode de réalisation d'un circuit de réveil du microcontrôleur ; et
les figures 4A, 4B et 4C illustrent, sous forme de chronogrammes, le fonctionnement du circuit de la figure 3.

### Description détaillée

De mêmes éléments ont été désignés par de mêmes références aux différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les éléments utiles à la compréhension des modes de réalisation décrits ont été représentés et seront détaillés. En particulier, les éléments présents dans le microcontrôleur dont on contrôle la mise en veille n'ont pas été détaillés, les modes de réalisation décrits étant compatibles avec les applications usuelles. Lorsque l'on fait référence aux termes "environ", "approximativement" ou "de l'ordre de", cela signifie à 10 % près, de préférence à 5 % près.

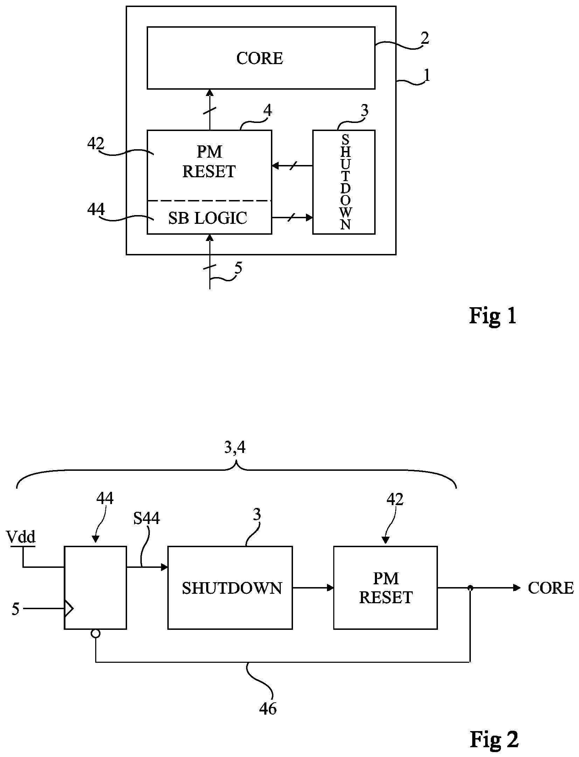

La figure 1 représente, de façon schématique, un mode de réalisation d'un microcontrôleur 1. Dans l'exemple représenté en figure 1, le microcontrôleur comporte un coeur 2 (CORE) et un circuit 4 de redémarrage ou réinitialisation de l'alimentation du coeur 2.

Pour simplifier, tous les circuits internes au microcontrôleur 1 n'ont pas été représentés. Seuls les circuits impliqués dans la mise en veille et le réveil ont été représentés. En particulier, le microcontrôleur 1 comporte des éléments de mémorisation volatile et non volatile et divers coprocesseurs et circuits d'entrée-sortie qui n'ont pas été illustrés. De plus, on considère la fonction de redémarrage du circuit car, comme on le verra par la suite, c'est cette fonction qui peut poser problème. Toutefois, le circuit 4 comporte généralement également d'autres fonctions de contrôle d'alimentation.

Dans une solution usuelle, lors d'une mise en veille, l'alimentation du coeur 2 du microcontrôleur est coupée. Toutefois, l'équivalent du circuit 4 reste alimenté afin d'être en mesure de détecter un besoin de redémarrage en interprétant les entrées-sorties 5 du microcontrôleur.

Les modes de réalisation décrits tirent leur origine d'une nouvelle analyse des besoins d'un microcontrôleur en considérant que certaines applications n'ont pas besoin d'une surveillance de leur alimentation.

Partant de ce constat, on peut alors éteindre le bloc de surveillance de l'alimentation. Cependant, l'une des raisons pour lesquelles ce bloc de surveillance de l'alimentation 4 n'est généralement jamais coupé est qu'il faut être capable de détecter un redémarrage lié à une baisse suivie d'une remontée de la tension d'alimentation. Dans les solutions usuelles, si on coupe le bloc de surveillance d'alimentation 4, on ne parvient pas à réveiller correctement le système pour redémarrer le microcontrôleur. En particulier, certains circuits logiques prennent alors des états indéterminés à la montée d'alimentation. Le démarrage du bloc de détection d'alimentation peut alors être empêché par ces états indéterminés. La conséquence de l'ajout de cette capacité d'arrêt du bloc de surveillance d'alimentation serait alors de rendre le démarrage du microcontrôleur imprédictible (démarrage impossible suivant l'état indéterminé).

On prévoit d'adjoindre au microcontrôleur et, plus particulièrement à son bloc de réinitialisation du circuit 4 de surveillance de l'alimentation, un module d'extinction/allumage 3 (SHUTDOWN) .

Pour cela, on distingue, dans le circuit 4, une fonction 42 (PM RESET) de redémarrage ou réinitialisation de l'alimentation (Power Management), donc du système, et une fonction logique 44 (SB LOGIC) de détection d'extinction/allumage de la fonction 42.

Les deux fonctions 42 et 44 du circuit 4 communiquent avec le module 3 séparément. Seule la fonction 42 communique avec le coeur 2 pour le réveiller. La fonction 44 intercepte quant à elle une demande de réveil provenant de l'extérieur du microcontrôleur 2 et, au lieu de la transmettre vers le circuit 42, la transmet au module 3 qui fournit la commande de réinitialisation ou de démarrage de l'alimentation du circuit 4 qui gère l'alimentation du reste du produit (microcontrôleur).

Ainsi, dans les périodes de veille, seuls le bloc logique 44 et le module 3 restent actifs, ce qui réduit considérablement la consommation.

La figure 2 représente, de façon très schématique, un mode de réalisation d'une interconnexion entre les fonctions 42, 44 et 3, faisant ressortir l'interception du signal logique de réinitialisation du bloc 42 par le module 3.

Dans cet exemple, la fonction logique 44 est assurée, pour chaque ressource externe susceptible de réveiller le microcontrôleur, par une bascule dont une entrée d'horloge, active par exemple sur front montant, reçoit (entrées 5) une information de réactivation du microcontrôleur (de sortie de veille). La sortie S44 de cette bascule est traitée par le module 3 dont une sortie active la réinitialisation (la réactivation) de l'alimentation par le bloc 42. Une fois le bloc 42 redémarré, le coeur 2 est de nouveau actif. Un rôle du circuit 3 est d'interrompre le signal de sortie de la bascule 44 afin d'éviter que l'activation d'une réinitialisation du circuit 42 provoque une réinitialisation de la bascule (liaison 46 entre la sortie du bloc 42 et l'entrée de réinitialisation de la bascule).

Le nombre de bascules 44 dépend du nombre d'entrées 5 de réveil possible du microcontrôleur 1.

En pratique, le module 3 se contente d'interrompre le signal de réinitialisation en fonction de l'état de l'alimentation. En d'autres termes, le circuit 3 ne modifie pas le signal de réinitialisation si l'alimentation est active mais le retarde lors d'un réveil.

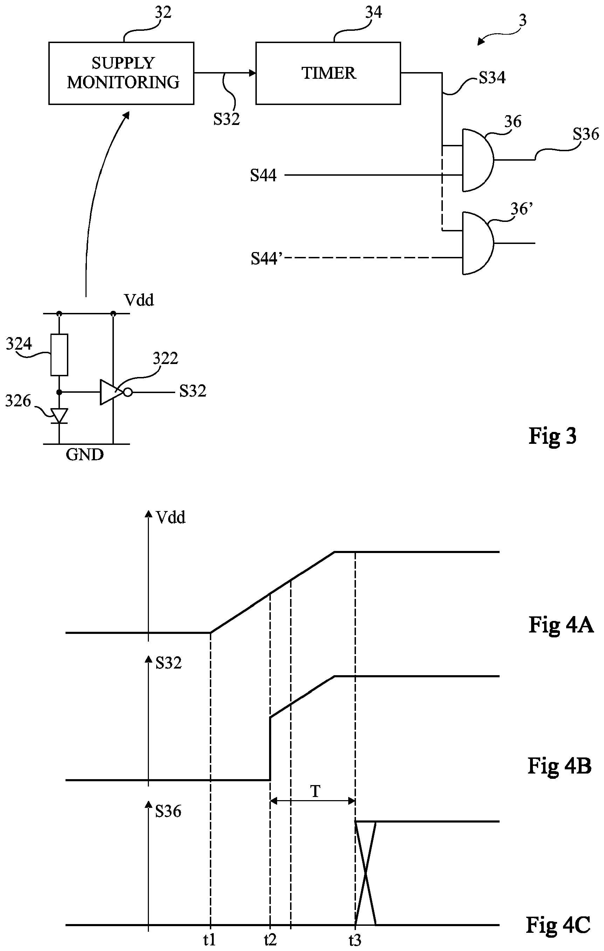

La figure 3 est un schéma-bloc simplifié d'un mode de réalisation du module 3.

Selon ce mode de réalisation, le module 3 comporte un bloc 32 (SUPPLY MONITORING) de détection de la tension d'alimentation Vdd du microcontrôleur qui détecte donc si la fonction 42 d'alimentation est ou non active. A titre d'exemple particulier de réalisation, le détecteur 32 comporte un inverseur logique 322 alimenté par la tension Vdd (rails Vdd et GND) appliquée au microcontrôleur et dont l'entrée est connectée au point milieu d'une association en série d'une résistance 324 et d'une diode 326. La valeur de la résistance 324 fixe le seuil de basculement de l'inverseur 322.

Le résultat S32 de la détection traverse un retardateur 34 (TIMER) avant d'être appliqué sur une première entrée d'une porte logique 36 de type ET. La deuxième entrée de la porte 36 reçoit le signal S44 de sortie de la bascule 44.

En cas de pluralité d'entrées 5, donc de bascules 44, chaque bascule est associée à une porte logique (dans l'exemple représenté une seconde porte 36') dont une première entrée reçoit la sortie du retardateur 34 et dont une deuxième entrée reçoit la sortie (par exemple S44') de la bascule concernée.

En pratique, le circuit 42 inclut également une fonction de surveillance de l'alimentation Vdd. Toutefois, cette fonction doit être précise pour le fonctionnement du microcontrôleur 1, ce qui implique une consommation significative. La détection opérée par le module 3 ayant pour seule fonction de masquer l'état de la commande de démarrage, qui peut être indéterminé à très basse tension ou au début de la montée de l'alimentation, n'a pas besoin de cette précision et peut être très simple (et de faible consommation) comme illustré en figure 3.

Les figures 4A, 4B et 4C illustrent, par des chronogrammes, le fonctionnement du circuit de la figure 3. La figure 4A représente un exemple de variation de la tension Vdd lors d'un réveil. La figure 4B représente l'allure correspondante du signal S32. La figure 4C représente l'allure correspondante du signal S36 de sortie de la porte 36.

On suppose un état initial dans lequel la tension Vdd est nulle, c'est-à-dire que l'alimentation est coupée (microcontrôleur en veille).

A un instant t1, la tension Vdd se met à croitre sous l'effet d'un réveil du système (commutation du signal 5, figure 2). Lorsque la tension Vdd atteint (instant t2) le seuil, fixé par la résistance 324 et la diode 326, la sortie S32 de l'inverseur 322 reproduit la valeur de la tension Vdd. La temporisation T fixée par le circuit 34 fait qu'à un instant t3 ultérieur, la sortie S36 de la porte 36 bascule vers l'état haut. En effet, la sortie de la bascule 44 est à l'état haut depuis que le signal 5 a commuté.

La temporisation T est choisie pour que le niveau de la tension Vdd à l'issue de la durée T soit supérieur au seuil de déclenchement de l'entrée de réinitialisation du circuit 42. Ainsi, à l'issue de la temporisation T, lorsque le signal est fourni en sortie du circuit 34, la tension Vdd est suffisante pour que le circuit 42 soit activé immédiatement. Le démarrage du circuit 42 de gestion de l'alimentation du microcontrôleur s'effectue donc correctement. Une fois que la tension est rétablie par le circuit 42, la bascule 44 est reinitialisée (figure 2) et est ainsi prête pour un redémarrage ultérieur.

Un avantage des modes de réalisation décrits est qu'ils règlent le problème éventuel d'un état inconnu de sortie de la ou des bascules 44 lors d'un réveil du système.

Il est désormais possible de mettre en veille le bloc d'alimentation 4 (à l'exception de la fonction logique 44) et de le réveiller quand nécessaire.

Un autre avantage est que le processus de mise en veille (d'extinction) n'a, dans la plupart des cas, pas besoin d'être modifié. En effet, il suffit que le système de réinitialisation (reset) possède une commande de démarrage/arrêt, ce qui en pratique est quasiment toujours le cas.

Un autre avantage des modes de réalisation décrits est qu'ils n'introduisent qu'une faible consommation résiduelle.

Divers modes de réalisation ont été décrits. Diverses variantes et modifications apparaîtront à l'homme de l'art. En particulier, le nombre d'entrées traitées par le circuit 3 dépend du nombre d'entrées 5 de réveil du microcontrôleur. De plus, le choix des seuils de détection dépend également de l'application. Enfin, la mise en oeuvre pratique des modes de réalisation qui ont été décrits est à la portée de l'homme du métier à partir des indications fonctionnelles données ci-dessus.

## Revendications

1. Microcontrôleur (1) comportant :
un coeur (2) ;
une unité (4) de gestion de l'alimentation du cœur (2) comportant :
une bascule (44) ayant une entrée d'horloge adaptée à recevoir un signal externe (5) de sortie d'un mode de veille pour réveiller le microcontrôleur, une entrée de donnée configurée adaptée à recevoir une tension d'alimentation (Vdd), une entrée de réinitialisation et une sortie (S44) ; et
un circuit (42) configuré pour générer un signal de réinitialisation de l'alimentation du cœur (2), ce signal étant aussi appliqué à l'entrée de réinitialisation de la bascule (44),
**caractérisé en ce qu'**il comporte :
un module (3) configuré pour intercepter le signal de sortie (S44) de la bascule (44) et pour fournir une commande (S36) de réinitialisation du circuit (42), le module (3) comportant :
un bloc (32) de détection de la tension d'alimentation (Vdd) du microcontrôleur,
un retardateur (34) connecté à la sortie (S32) dudit bloc (32), et
une porte logique (36) de type ET configurée pour combiner la sortie (S34) du retardateur (34) et la sortie (S44) de la bascule (44) pour fournir la commande (S36) de réinitialisation du circuit (42).

2. Microcontrôleur selon la revendication 1, dans lequel ledit bloc (32) de détection de la tension d'alimentation (Vdd) du microcontrôleur est configuré pour, lors d'un réveil, déclencher une temporisation quand le niveau de la tension d'alimentation (Vdd) atteint un seuil prédéterminé.

## Patentansprüche

1. Mikrocontroller (1) aufweisend:
einen Kern (2);
eine Einheit (4) zur Verwaltung der Stromversorgung des Kerns (2), die Folgendes aufweist:
ein Flipflop (44) mit einem Takteingang, der zum Empfang eines externen Aufwecksignals (5) zum Aufwecken des Mikrocontrollers geeignet ist, einem konfigurierten Dateneingang, der zum Empfang einer Stromversorgungsspannung (Vdd) geeignet ist, einem Rücksetzeingang und einem Ausgang (S44); und
eine Schaltung (42), die konfiguriert ist zum Erzeugen eines Signals zum Zurücksetzen der Stromversorgung des Kerns (2), wobei dieses Signal auch an den Rücksetzeingang des Flipflops (44) angelegt wird,
**dadurch gekennzeichnet, dass** er Folgendes aufweist:
ein Modul (3), das konfiguriert ist zum Abfangen des Ausgangssignals (S44) des Flipflops (44) und zum Liefern eines Steuersignals (S36) zum Zurücksetzen der Schaltung (42), wobei das Modul (3) Folgendes aufweist:
einen Block (32) zum Detektieren der Mikrocontroller-Stromversorgungsspannung (Vdd) d,
ein Verzögerungselement (34), das mit dem Ausgang (S32) des Blocks (32) verbunden ist, und
ein logisches UND-Gatter (36), das so konfiguriert ist zum Kombinieren des Ausgangs (S34) des Verzögerungselements (34) und des Ausgangs (S44) des Flipflops (44), um das Steuersignal (S36) zum Zurücksetzen der Schaltung (42) zu liefern.

2. Mikrocontroller nach Anspruch 1, wobei der Block (32) zum Detektieren der Mikrocontroller-Stromversorgungsspannung (Vdd) konfiguriert ist, beim Aufwachen, zum Auslösen einer Unterbrechung, wenn das Niveau der Stromversorgungsspannung (Vdd) einen vorgegebenen Schwellenwert erreicht.

## Claims

1. Microcontroller (1) comprising:
a core (2);
a unit (4) for managing the power supply of the core (2) comprising:
a flip-flop (44) having a clock input adapted to receiving an external wake up signal (5) to wake up the microcontroller, a configured data input adapted to receiving a power supply voltage (Vdd), a reset input, and an output (S44); and
a circuit (42) configured to generate a signal for resetting the power supply of the core (2), this signal also being applied to the reset input of the flip-flop (44),
**characterized in that** it comprises:
a module (3) configured to intercept the output signal (S44) of the flip-flop (44) and to deliver a control signal (S36) for resetting the circuit (42), the module (3) comprising:
a block (32) for detecting the microcontroller power supply voltage (Vdd),
a delay element (34) connected to the output (S32) of said block (32), and
a logic AND-type gate (36) configured to combine the output (S34) of the delay element (34) and the output (S44) of the flip-flop (44) to deliver the control signal (S36) for resetting the circuit (42).

2. Microcontroller according to claim 1, wherein said block (32) for detecting the microcontroller power supply voltage (Vdd) is configured to, at a waking up, trigger an interruption when the level of the power supply voltage (Vdd) reaches a predetermined threshold.
